# EUROPÄISCHE PATENTSCHRIFT

(11) **EP 2 011 378 B1**
(45) Veröffentlichungstag und Bekanntmachung des Hinweises auf die Patenterteilung: **09.11.2011**
(21) Anmeldenummer: 07723154.6
(22) Anmeldetag: 09.03.2007
(51) Int. Cl.: H05K 7/20, H02B 1/56

(54) **ANORDNUNG ZUM KÜHLEN VON ELEKTRISCHEN BAUGRUPPEN UND GERÄTEN**
SYSTEM FOR COOLING ELECTRICAL COMPONENTS AND DEVICES
DISPOSITIF POUR REFROIDIR DES MODULES ET APPAREILS ELECTRIQUES

(30) Priorität: 21.04.2006 DE 202006006441 U
(43) Veröffentlichungstag der Anmeldung: 07.01.2009
(73) Patentinhaber: Knürr GmbH, 94424 Amstorf (DE)
(72) Erfinder: BRETSCHNEIDER, Rainer, 01623 Lommatzsch (DE); GALLASCH, Lars, 01665 Löthain (DE); TREPTE, Wolfgang, 01665 Zehren (DE)
(74) Vertreter: Heim, Hans-Karl
(86) Internationale Anmeldenummer: PCT/EP2007/002096
(87) Internationale Veröffentlichungsnummer: WO 2007/121811

(56) Entgegenhaltungen:
- WO-A-00/62591
- WO-A-2004/062332
- DE-A1- 10 038 821
- DE-C2- 19 755 944

## Beschreibung

Die Erfindung betrifft eine Anordnung zum Kühlen von in einem Gehäuse angeordneten elektrischen und elektronischen Baugruppen und Geräten gemäß dem Oberbegriff des Anspruchs 1.

Die Erfindung ist insbesondere für Gehäuse und Geräteschränke der Telekommunikationstechnik vorgesehen, welche als Outdoor-Schränke und -Gehäuse im Freien aufgestellt werden. Diese Outdoor-Gehäuse und -Schränke sind den Umwelteinflüssen und Witterungsbedingungen mehr oder weniger stark ausgesetzt und müssen derart ausgebildet sein, beziehungsweise eine entsprechende Abdichtung aufweisen, dass Fremdkörper, Staub, Schmutz, Wasser und Feuchtigkeit nicht in den Innenraum gelangen und zu einer Beeinträchtigung oder zu einem Ausfall der Baugruppen und Geräte führen können. In der Regel sind Schutzbestimmungen nach den IP-Klassen, beispielsweise ein IP-Schutzwert von 55, einzuhalten, das heißt, dass die Gehäuse und Schränke staubgeschützt sind und Strahlwasser aus jeder Richtung standhalten müssen.

Für Outdoor-Gehäuse und -Schränke sind Anordnungen bekannt, welche einen mit wenigstens einem Lüfter zusammenwirkenden Membranfilter in einem Lufteinlass eines Gehäuses aufweisen (DE 197 55 944 C2). Die Membranfilter dienen der Oberflächenfilterung von Schmutzpartikeln aus der angesaugten Frischluft und der Abscheidung von Feuchtigkeit und Flüssigkeiten. Die Membranfilter, welche beispielsweise aus Polyfluorethylen (Teflon) mit einem stabilisierenden Trägermaterial bestehen, weisen eine sehr kleine Porengröße auf und werden in einer Faltanordnung in einem Filterrahmen gehalten. Dadurch wird eine große Filteroberfläche und ein möglichst geringer Strömungswiderstand für die Kühlluft erreicht.

Bei den bekannten Anordnungen sind die Membranfilter an der Innenseite einer Gehäusewand oder Tür, welche mit Lüftungslöchern versehen ist, angeordnet. Eine Abdichtung des Membranfilters erfolgt an der Frischluftseite des Filters gegenüber der Gehäusewand oder Tür. Dabei wird die Wirkung der Dichtung durch die Druckdifferenz zwischen dem Innenluftdruck und dem Außenluftdruck beeinträchtigt. Außerdem ist bei dieser Anordnung ein Filtermaterial mit absoluter Fluiddichtheit erforderlich. Bei extremen Niederschlägen kann es trotz einer entsprechenden Ausbildung der Lüftungslöcher, beispielsweise bei einer lamellenartigen Ausbildung, zu einem Wassereintritt in den Filter kommen, was bei der derzeitigen Anwendung zur Ausbildung eines Wasserspiegels führt, der die Leistungsfähigkeit der für Strahlwasser ausgelegten Dichtung übersteigt und die Gefahr von Leckagen birgt. Auch bei einer entsprechenden Staub- und Schutzbelastung ist es nicht ausgeschlossen, dass der Membranfilter zugesetzt wird. Es besteht dann die Notwendigkeit, den gesamten Filter auszuwechseln. Da die Kosten für einen Membranfilter relativ hoch sind, insbesondere, wenn der Filter aus einem brennbaren Material besteht und zusätzlich ein Brandschutzblech vorgesehen werden muss, und außerdem die Befestigung des Filters, welche in aller Regel mit Hilfe eines Schraubflansches erfolgt, relativ zeitaufwendig ist, ist das Auswechseln des Filters mit relativ hohen Kosten verbunden.

Der Erfindung liegt die **Aufgabe** zugrunde, eine Kühlungsanordnung zu schaffen, bei welcher ein kostengünstiger Filter eingesetzt und derart angeordnet wird, dass eine außerordentlich gute Abdichtung gewährleistet ist.

Erfindungsgemäß wird die Aufgabe durch die Merkmale des Anspruchs 1 gelöst. Zweckmäßige und vorteilhafte Ausgestaltungen sind in den Unteransprüchen und in der Figurenbeschreibung enthalten.

Ein Grundgedanke der Erfindung kann darin gesehen werden, einen Filter nicht mehr von innen an einer Gehäusewand oder Tür anzuordnen und gegen diese abzudichten, sondern mit Hilfe einer Halteeinrichtung, welche nachfolgend als Filterwanne bezeichnet wird, von außen anzuordnen.

Erfindungsgemäß ist die Filterwanne in einer Gehäusewand, insbesondere in einer Tür des Gehäuses, angeordnet und der in der Filterwanne aufgenommene Filter mit Hilfe einer umlaufenden Dichtung an der Luftaustrittsseite gegen die Filterwanne, vorzugsweise im Bereich des Wannenbodens, abgedichtet.

Die Filterwanne kann als relativ flache Halteeinrichtung und bevorzugt als eine Vertiefung ausgebildet sein.

Ein wesentlicher Vorteil dieser Anordnung besteht darin, dass der Filter durch die Saugwirkung des im Innenraum des Gehäuses herrschenden Unterdruckes an die Dichtung gepresst und dadurch die Dichtwirkung unterstützt wird. Diese erhöhte Dichtwirkung gewährleistet eine höhere Sicherheit gegen Falschluft und Wassereintritt. Es kann nur gefilterte und entfeuchtete beziehungsweise aerosolfreie Kühlluft in den Innenraum und zu den darin aufgenommenen Baugruppen und Geräten gelangen, und es wird die erforderliche Abführung der Verlustwärme erreicht. Eine Beeinträchtigung der Geräte und Baugruppen durch Umwelt- und Witterungseinflüsse kann vermieden und eine entsprechende Lebensdauer gewährleistet werden.

Ein weiterer Vorteil besteht darin, dass der in der Filterwanne lösbar und von außen anzuordnende Filter ein Glasvliesfilter oder ein Polypropylenfilter sein kann. Diese Filter sind an sich bekannt und werden beispielsweise in der Kraftfahrzeug- und Gebäudetechnik eingesetzt. Sie bestehen in der Regel aus einem gefalteten Feinfilter und einem Grobfilter, welcher einen Wasserablauf realisiert. Vorteilhafterweise sind die Glasvliesfilter und die Polypropylenfilter wesentlich kostengünstiger als ein Membranfilter, wobei sie in Bezug auf die Porengröße und den Abscheidegrad für Staub und Aerosole sowie bezüglich der Druckverluste den Anforderungen genügen.

Durch die Anordnung des Filters in einer Filterwanne wird die Bildung eines Wasserspiegels verhindert. In Verbindung mit der Filtergestaltung kann ein Abfließen von sich ansammelndem Fluid zuverlässig gesichert werden.

Die umlaufende Dichtung, welche zwischen dem Filter beziehungsweise dem Filterrahmen und der Filterwanne, insbesondere im Bereich des Wannenbodens, vorgesehen ist, kann als ein Dichtrahmen oder eine dispensierte Dichtung, Aufsteckdichtung oder Klebedichtung ausgebildet sein.

Zweckmäßigerweise sind die Filterwanne und insbesondere der darin aufgenommene Filter mit Hilfe einer Filterabdeckung abgedeckt, so dass der Filter gegen die Umwelt- und Witterungseinflüsse geschützt ist. Die Filterabdeckung ist vorteilhafterweise lösbar an der Tür beziehungsweise an der Gehäusewand, in welcher die Filterwanne ausgebildet ist, befestigt und kann im Falle eines erforderlichen Filterwechsels relativ rasch abgenommen werden, wodurch der Filter in der Filterwanne zugänglich wird.

Grundsätzlich kann die Filterwanne in die Gehäusewand und insbesondere in eine Tür integriert sein. Es besteht jedoch auch die Möglichkeit, die Filterwanne in einer Ausnehmung der Tür beziehungsweise einer Gehäusewand anzuordnen. Zweckmäßigerweise ist die Filterwanne dann mit einem Befestigungsflansch versehen, welcher außenseitig die Ausnehmung übergreift und an einem die Ausnehmung begrenzenden Randbereich der Tür oder Gehäusewand anliegt.

Es ist von Vorteil, dass die Filterabdeckung beabstandet von der Filterwanne und dem darin aufgenommenen Filter angeordnet werden kann. Dadurch wird ein Ansaugkanal beziehungsweise ein Luftverteilungsraum über die gesamte Lufteintrittsseite des Filters gebildet. Diese Anordnung ermöglicht es, Lufteinlass-bzw. Ansaugöffnungen so anzuordnen, dass Spritz- oder Strahlwasser nie direkt auf das Filtermaterial einwirken kann.

Die Lufteinlassöffnungen für die von wenigstens einem Lüfter angesaugte Frischluft aus der Umgebung des Gehäuses sind zweckmäßigerweise bodenseitig in der Filterabdeckung ausgebildet, und zur Abscheidung der Feuchtigkeit der Frischluft vor Erreichen des Filters sind vorteilhafterweise Abscheideelemente, beispielsweise Abscheidebleche, im unteren Bereich des Ansaugkanals angeordnet.

Der Filterrahmen des Filters kann bodenseitig an der Frischluftseite mit Ablauflöchern für abgeschiedenes Wasser oder Fluid versehen sein, um eine Beeinträchtigung des Filters zu verhindern.

Vorteilhaft sind an der Innenseite der Filterabdeckung Abstandshalter angeordnet, welche bis zu dem Filter reichen und eine stabile Anordnung des Filters und dessen Abdichtung in der Filterwand unterstützen.

Es ist von Vorteil, dass die Filterwanne gleichzeitig die Funktion eines Brandschutzbleches übernehmen kann. Beispielsweise kann die Filterwanne in die Ebene eines Türblattes oder einer Seitenverkleidung derart integriert sein, dass sie, ausgenommen die Dichtungen, nur eine zweidimensionale Ausdehnung hat. Die Filterabdeckung wäre dann entsprechend höher auszubilden.

Der Wannenboden, welcher parallel zu dem Filter und der Filterabdeckung und insbesondere vertikal angeordnet ist, weist Öffnungen für die gefilterte Frischluft auf.

Der Lüfter kann vorteilhaft in einem oberen Bereich und in einer Gehäusewand, beispielsweise in der Rückwand, welche der Tür beziehungsweise der Gehäusewand mit der Filterwanne und dem darin aufgenommenen Filter gegenüberliegt, angeordnet sein. Wenn der Filter und die komplementär ausgebildete Filterwanne nur einen Teilbereich der Tür beziehungsweise einer Gehäusewand einnehmen, kann der Lüfter auch oberhalb des Filters und der Filterwanne angeordnet werden. Eine zweckmäßige Lüfteranordnung kann auch im Einbau ober- oder unterhalb der Schrankabdeckung und geschützt durch ein Regendach bestehen.

Besonders zweckmäßig ist die Ausbildung einer frontseitigen Tür mit Filterwanne zur Aufnahme eines Glasvliesfilters oder Polypropylenfilters. Der Lüfter ist dann im oberen Bereich der Rückwand angeordnet und die mit der Verlustwärme beaufschlagte Abluft kann, zweckmäßigerweise in einem Abluftkanal, welcher von einer doppelwandigen Rückwand gebildet sein kann, an die Umgebung abgeführt werden. Abluftöffnungen in der doppelwandigen Rückwand sind dann vorteilhafterweise in einem bodenseitigen Bereich ausgebildet. Analog kann bei einer Lüfteranordnung unter dem Regendach oder in der Tür verfahren werden.

Die Erfindung wird nachstehend anhand einer Figurenbeschreibung weiter erläutert; in dieser zeigen in einer stark schematisierten Darstellung:
- Fig.: 1 einen Längsschnitt durch eine erfindungsgemäße Anordnung;
- Fig. 2: einen Horizontalschnitt nach Linie II-II der Fig. 1;
- Fig. 3: eine Explosivdarstellung der Filteranordnung von außen gesehen und
- Fig. 4: eine Explosivdarstellung der Filteranordnung von innen gesehen.

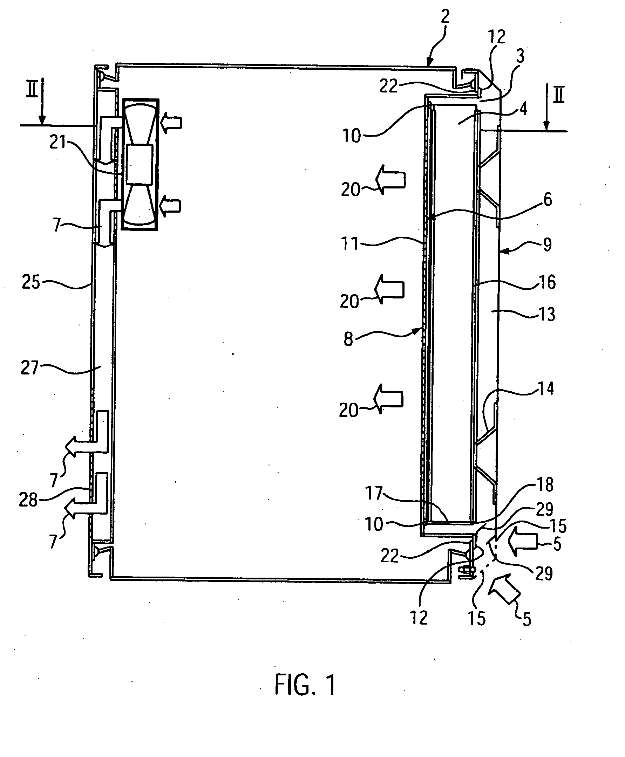

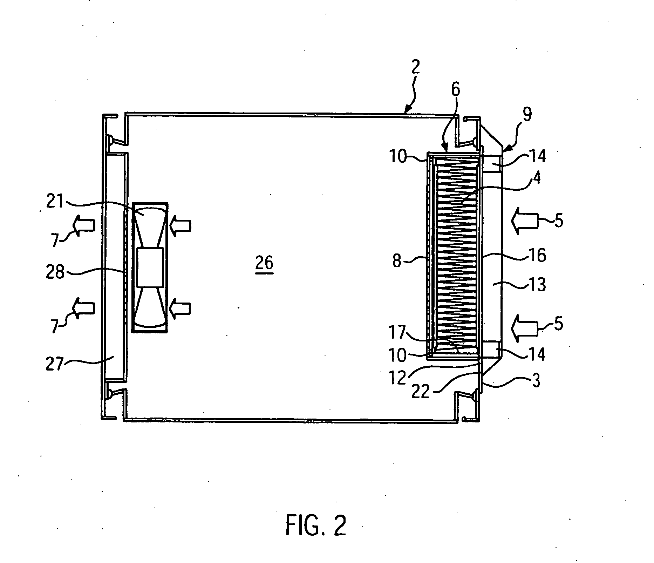

Bei der in den Figuren 1 und 2 gezeigten Anordnung zum Kühlen von in einem Gehäuse 2 angeordneten elektrischen und elektronischen Baugruppen und Geräten (nicht dargestellt), ist ein Lüfter 21 in einem oberen Bereich einer Rückwand 25 angeordnet.

Der Lüfter 21 saugt zur Abführung der Verlustwärme der Baugruppen und Geräte im Innenraum 26 des Gehäuses 2 Frischluft 5 über Lufteinlassöffnungen 15 und eine Filteranordnung im Bereich einer frontseitigen Tür 3 an. Die Filteranordnung besteht aus einem Filter 4, welcher ein Glasvliesfilter oder ein Polypropylenfilter sein kann und in einem Filterrahmen 17 angeordnet ist. Der Filter 4 ist in einer Filterwanne 6 aufgenommen, welche in diesem Ausführungsbeispiel als eine Vertiefung ausgebildet und in einer Ausnehmung 23 der Tür 3 angeordnet ist.

Die Filterwanne 6 ist im Prinzip komplementär zu dem Filter 4 ausgebildet und eine Frischluftseite 16 des Filters 4 schließt nahezu bündig mit der Filterwanne 6 ab, während an einer Luftaustrittsseite 8 des Filters 4 eine Dichtung 10 umlaufend angeordnet ist, um den Filter 4 gegen die Filterwanne 6 abzudichten. Dabei liegt die Dichtung 10 im Bereich eines Wannenbodens 11 und damit an der Saugseite an, wodurch die Dichtwirkung erhöht und verbessert wird. Der Wannenboden 11 ist mit Öffnungen 19 versehen, durch welche die gefilterte Frischluft 20 in den Innenraum 26 des Gehäuses 2 gelangt.

Die Filterwanne 6 weist Befestigungsflansche 12 auf, und diese Befestigungsflansche 12 übergreifen einen Randbereich 22 der Tür 3, welcher die Ausnehmung 23 der Tür 3 umgibt.

Im Abstand zu dem Filter 3 ist außenseitig eine Filterabdeckung 9 angeordnet, in deren bodenseitigem Bereich die Lufteinlassöffnungen 15 für die Frischluft 5 ausgebildet sind. Die Filterabdeckung 9 ermöglicht neben der Erzeugung eines Dichtungsdruckes einen Schutz gegen eine direkte Beaufschlagung des Filters 4 mit Fluidteilchen der Frischluft und aufgrund einer lösbaren Anordnung an der Tür 3 außerdem einen schnellen Austausch des Filters 4, wenn dies erforderlich wird.

Durch die beabstandete Anordnung der Filterabdeckung 9 ist ein Ansaugkanal 13 gebildet, in welchem die angesaugte Frischluft 5 verteilt und über die gesamte Fläche des Filters 4 in den Innenraum 26 gelangt. Abstandshalter 14 sind an der Innenseite der Filterabdeckung 9 befestigt und reichen bis zu der Frischluftseite des Filters 4. Im bodenseitigen Bereich nahe der Lufteinlassöffnungen 15 für die Frischluft 5 sind Abscheidebleche 29 für Fluidtröpfchen in der Frischluft 5 angeordnet, und im bodenseitigen Filterrahmen 17 sind Ablauflöcher 18 für eingedrungenes Fluid ausgebildet.

Die Rückwand 25 des Gehäuses 2 ist in diesem Ausführungsbeispiel doppelwandig ausgebildet und innenseitig im Bereich des Lüfters 21 sowie außenseitig in einem unteren Bereich mit Abluftöffnungen 28 versehen. Die vom Lüfter 21 angesaugte Abluft wird über den Abluftkanal 27 und die bodenseitigen Abluftöffnungen 28 an die Gehäuseumgebung abgeführt.

Fig. 2 verdeutlicht zusätzlich die Längsfaltung des Filters 4. Im Übrigen sind identische Merkmale mit identischen Bezugszeichen versehen.

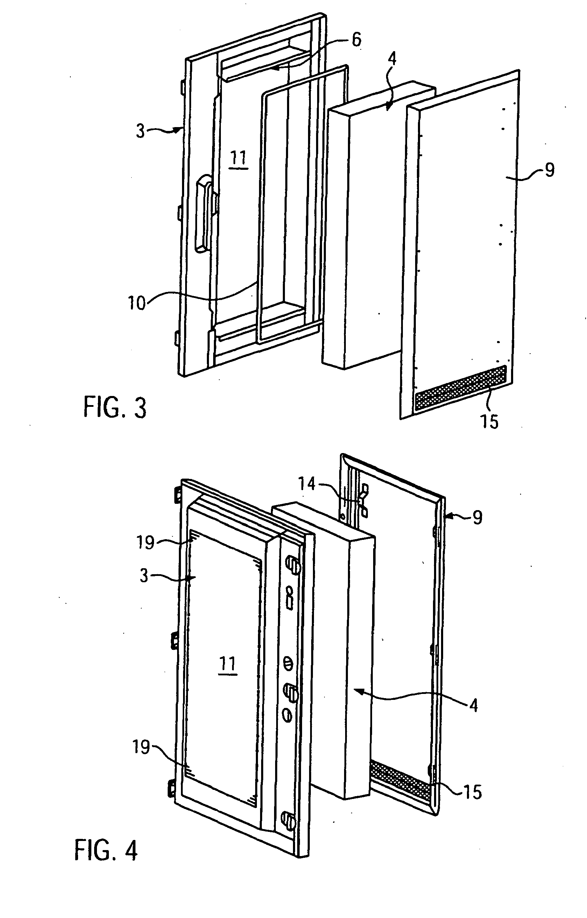

Die Explosivdarstellungen der Fig. 3 und 4 zeigen eine Filterwanne 6, welche in eine Tür 3 integriert und als eine Vertiefung (siehe Fig. 4) ausgebildet ist. Zur Abdichtung des Filters 4 gegenüber der Filterwanne 6 ist eine Dichtung 10 rahmenartig ausgebildet und wird im Bereich des Wannenbodens 11 zwischen dem Filter 4 und der Filterwanne 6 angeordnet.

Eine Filterabdeckung 9 wird von außen unter Abdeckung des Filters 4 und der Filterwanne 6 lösbar angeordnet. Bodenseitig sind in der Filterabdeckung 9 Lufteinlassöffnungen 15 für die Frischluft 5 (siehe Fig. 1 und 2) ausgebildet.

Fig. 4 zeigt zusätzlich Abstandshalter 14, welche innenseitig an der Filterabdeckung 9 angebracht sind. Außerdem ist gezeigt, dass die Filterabdeckung 9 über Scharniere 30 an der Tür 3 angelenkt ist, wodurch eine Wartung und ein Wechsel des Filters 4 außerordentlich einfach und schnell durchgeführt werden können.

Die in den Figuren dargestellte Bauart des Lüfters ist nur beispielhaft, und es können ebenso auch Radial-, Diagonal- oder Walzenlüfter zur Anwendung kommen.

## Patentansprüche

1. Anordnung zum Kühlen von in einem Gehäuse angeordneten elektrischen und elektronischen Baugruppen und Geräten, mit wenigstens einem Lüfter (21), welcher Frischluft (5) aus der Gehäuseumgebung durch Lufteinlassöffnungen (15) des Gehäuses (2) einem Filter (4) und danach dem Innenraum (26) des Gehäuses (2) zuführt sowie die durch die Baugruppen und Geräte erwärmte Abluft (7) an die Gehäuseumgebung abführt,
wobei der Filter (4) an einer Gehäusewand oder Tür (3) angeordnet ist,
**dadurch gekennzeichnet,**
**dass** eine Filterwanne (6) zur Anordnung des Filters (4) vorgesehen und in der Gehäusewand oder Tür (3) angeordnet ist und
**dass** der Filter (4) lösbar und von außen austauschbar in der Filterwanne (6) aufgenommen und mit Hilfe einer umlaufenden Dichtung (10) an seiner Luftaustrittsseite (9) gegen die Filterwanne (6) abgedichtet ist.

2. Anordnung nach Anspruch 1,
**dadurch gekennzeichnet,**
**dass** der Filter (4) ein Glasvliesfilter oder ein Polypropylenfilter ist.

3. Anordnung nach Anspruch 1 oder 2,
**dadurch gekennzeichnet,**
**dass** die umlaufende Dichtung (10) ein Dichtrahmen ist oder als eine dispensierte Dichtung, Aufsteckdichtung oder Klebedichtung ausgebildet ist.

4. Anordnung nach einem der vorhergehenden Ansprüche,
**dadurch gekennzeichnet,**
**dass** die Filterwanne (6) und der darin aufgenommene Filter (4) durch eine außenseitig angeordnete Filterabdeckung (9) abgedeckt.sind.

5. Anordnung nach einem der vorhergehenden Ansprüche,
**dadurch gekennzeichnet,**
**dass** die Filterabdeckung (9) lösbar an der Gehäusewand oder Tür (3) befestigt ist.

6. Anordnung nach einem der vorhergehenden Ansprüche,
**dadurch gekennzeichnet,**
**dass** die Filterwanne (6) in die Gehäusewand oder Tür (3) integriert ist (Fig. 3 und 4).

7. Anordnung nach einem der Ansprüche 1 bis 5,
**dadurch gekennzeichnet,**
**dass** die Filterwanne (6) in einer Ausnehmung (23) der Gehäusewand oder Tür (3) angeordnet ist und einen Befestigungsflansch (12) aufweist, welcher die Ausnehmung (23) übergreift und an einem Randbereich (22) anliegt (Fig. 1 und 2).

8. Anordnung nach einem der vorhergehenden Ansprüche,
**dadurch gekennzeichnet,**
**dass** die Filterwanne (6) als nahezu ebenes Brandschutzblech oder als eine Vertiefung ausgebildet ist und einen Wannenboden (11) mit Öffnungen (19) für die gefilterte Frischluft (20) aufweist.

9. Anordnung nach einem der vorhergehenden Ansprüche,
**dadurch gekennzeichnet,**
**dass** der Filter (4) einen Filterrahmen (17) aufweist, welcher an der Frischluftseite (16) bodenseitig mit Ablauflöchern (18) für abgeschiedenes Wasser versehen ist.

10. Anordnung nach einem der vorhergehenden Ansprüche,
**dadurch gekennzeichnet,**
**dass** die Filterabdeckung (9) im Abstand von dem in der Filterwanne (6) aufgenommenen Filter (4) an der Gehäusewand oder Tür (3) angeordnet ist und ein Ansaugkanal (13) zwischen der Frischluftseite (16) des Filters (4) und der Filterabdeckung (9) ausgebildet ist.

11. Anordnung nach einem der vorhergehenden Ansprüche,
**dadurch gekennzeichnet,**
**dass** die Lufteinlassöffnungen (15) für die Frischluft (5) in einem bodenseitigen Bereich der Filterabdeckung (9) ausgebildet sind.

12. Anordnung nach einem der vorhergehenden Ansprüche,
**dadurch gekennzeichnet,**
**dass** im Ansaugkanal (13) zur Reduzierung des Wassereintrages Abscheidebleche (29) angeordnet sind.

13. Anordnung nach einem der vorhergehenden Ansprüche,
**dadurch gekennzeichnet,**
**dass** Abstandshalter (14) zwischen der Filterabdeckung (9) und dem Filter (4) angeordnet sind.

14. Anordnung nach einem der vorhergehenden Ansprüche,
**dadurch gekennzeichnet,**
**dass** der Lüfter (21) in einem oberen Bereich einer Gehäusewand 25 oder Tür, welcher der Filterwanne (6) mit dem Filter (4) gegenüberliegt, angeordnet ist.

15. Anordnung nach einem der vorhergehenden Ansprüche,
**dadurch gekennzeichnet,**
**dass** ein Abluftkanal (27) mit bodenseitig angeordneten Abluftöffnungen (28) in einer Gehäusewand (25) oder Tür ausgebildet ist, über welche die vom Lüfter (21) angesaugte Abluft (7) an die Gehäuseumgebung abführbar ist.

## Claims

1. Arrangement for cooling electrical and electronic components and devices placed in a housing, comprising:
at least one fan (21) which supplies fresh air (5) from the housing environment through air inlet openings (15) of said housing (2) to a filter (4) and subsequently to the interior (26) of said housing (2) and removes to the housing environment exhaust air (7) heated by the components and devices,
the filter (4) being located on a housing wall or a door (3),
**characterized in that**
a filter trough (6) is provided for positioning of the filter (4) and is located in the housing wall or door (3) and
that the filter (4) is received in the filter trough (6) detachably and replaceably from the outside and is sealed with the aid of a circumferential seal (10) on its air outlet side (8) against the filter trough (6).

2. Arrangement according to claim 1,
**characterized in that**
the filter (4) is a glass fibre mat filter or a polypropylene filter.

3. Arrangement according to claim 1 or 2,
**characterized in that**
the circumferential seal (10) is a sealing frame or is constructed as a dispensed seal, a clip-on seal or an adhesive seal.

4. Arrangement according to one of the preceding claims,
**characterized in that**
the filter trough (6) and the filter (4) received therein are covered by an externally positioned filter cover (9).

5. Arrangement according to one of the preceding claims,
**characterized in that**
the filter cover (9) is detachably fixed to the housing wall or door (3).

6. Arrangement according to one of the preceding claims,
**characterized in that**
the filter trough (6) is integrated into the housing wall or door (3) (figs. 3 and 4).

7. Arrangement according to one of the claims 1 to 5,
**characterized in that**
the filter trough (6) is placed in a recess (23) of the housing wall or door (3) and has an attachment flange (12), which overlaps the recess (23) and is adjacent to a marginal area (22) (figs. 1 and 2).

8. Arrangement according to one of the preceding claims,
**characterized in that**
the filter trough (6) is constructed as a virtually planar fire protection plate or as a depression and has a trough bottom (11) with openings (19) for the filtered fresh air (20).

9. Arrangement according to one of the preceding claims,
**characterized in that**
the filter (4) has a filter frame (17) which, on the fresh air side (16), is provided at the bottom with drain holes (18) for separated water.

10. Arrangement according to one of the preceding claims,
**characterized in that**
the filter cover (9) is placed on the housing wall or door (3) spaced from the filter (4) received in the filter trough (6) and a suction duct (13) is formed between the fresh air side (16) of the filter (4) and the filter cover (9).

11. Arrangement according to one of the preceding claims,
**characterized in that**
the air inlet openings (15) for the fresh air (5) are formed in a bottom area of the filter cover (9).

12. Arrangement according to one of the preceding claims,
**characterized in that**
separating plates (29) are provided in the suction duct (13) for reducing the entry of water.

13. Arrangement according to one of the preceding claims,
**characterized in that**
spacers (14) are located between the filter cover (9) and filter (4).

14. Arrangement according to one of the preceding claims,
**characterized in that**
the fan (21) is positioned in an upper area of a housing wall (25) or door, which faces the filter trough (6) with the filter (4).

15. Arrangement according to one of the preceding claims,
**characterized in that**
an exhaust air duct (27) with exhaust air openings (28) arranged on the bottom side is formed in a housing wall (25) or door by means of which the exhaust air (7) sucked by fan (21) can be led off to the housing environment.

## Revendications

1. Dispositif pour refroidir des appareils et modules électriques et électroniques placés dans un boîtier, avec au moins un ventilateur (21) qui, à travers des ouvertures (15) d'entrée d'air du boîtier, envoie de l'air frais (5) depuis l'environnement du boîtier vers un filtre (4), puis à l'intérieur (26) du boîtier (2), et qui évacue l'air usé (7) chauffé par les appareils de modules vers l'environnement du boîtier,
dans lequel le filtre (4) est placé sur une paroi ou porte (3) du boîtier,
***caractérisé***
***en ce* qu'**un bac (6) de filtre est prévu pour placer le filtre (4) et est placé dans la paroi ou porte (3) du boîtier, et
***en ce que*** le filtre (4) est placé de manière amovible et interchangeable de l'extérieur dans le bac (6) du filtre et est rendu hermétique par rapport au bac (6) de filtre à l'aide d'un joint périphérique (10) sur sa face (9) de sortie d'air.

2. Dispositif selon la revendication 1, ***caractérisé en ce que*** le filtre (4) est un filtre en fibres de verre ou un filtre en polypropylène.

3. Dispositif selon la revendication 1 ou 2, ***caractérisé en* ce *que*** le joint périphérique (10) est un cadre d'étanchéité ou est conformé en joint moulant, joint enfiché ou joint collé.

4. Dispositif selon l'une quelconque des revendications précédentes, ***caractérisé en ce que*** le bac (6) du filtre et le filtre (4) qui s'y trouve sont recouverts par un capot (9) de filtre placé du côté extérieur.

5. Dispositif selon l'une quelconque des revendications précédentes, ***caractérisé en ce que*** le capot (9) du filtre est fixé de manière amovible sur la paroi ou porte (3) du boîtier.

6. Dispositif selon l'une quelconque des revendications précédentes, ***caractérisé en ce que*** le bac (6) du filtre est intégré dans la paroi ou porte (3) du boîtier (Fig. 3 et 4).

7. Dispositif selon l'une quelconque des revendications 1 à 5, ***caractérisé en ce que*** le bac (6) du filtre est placé dans un évidement (23) de la paroi ou porte (3) du boîtier et comprend une bride de fixation (12) qui recouvre l'évidement (23) et s'appuie contre une zone de bord (22) (Fig. 1 et 2).

8. Dispositif selon l'une quelconque des revendications précédentes, ***caractérisé en ce que*** le bac (6) du filtre est conformé en tôle anti-incendie quasi plane ou en renfoncement et comprend un fond (11) de bac avec des ouvertures (19) pour l'air frais filtré (20).

9. Dispositif selon l'une quelconque des revendications précédentes, ***caractérisé* en *ce que*** le filtre (4) est placé dans un cadre (17) de filtre qui, au niveau du fond du côté air frais (16), est muni d'orifices d'écoulement (14) pour l'eau séparée.

10. Dispositif selon l'une quelconque des revendications précédentes, ***caractérisé* en *ce que*** le capot (9) du filtre est placé sur la paroi ou porte (3) du boîtier à distance du filtre (4) placé dans le bac (6) du filtre et un canal d'aspiration (13) est formé entre le côté air frais (16) du filtre (4) et le capot (9) du filtre.

11. Dispositif selon l'une quelconque des revendications précédentes, ***caractérisé en ce que*** les ouvertures (15) d'entrée d'air pour l'air frais (5) sont formées dans une zone de fond du capot (9) du filtre.

12. Dispositif selon l'une quelconque des revendications précédentes, ***caractérisé* en *ce que*** des tôles de séparation (29) sont prévues dans le canal d'aspiration (13) pour réduire l'entrée d'eau.

13. Dispositif selon l'une quelconque des revendications précédentes, ***caractérisé en ce que*** des éléments d'écartement (14) sont placés entre le capot (9) du filtre et le filtre (4).

14. Dispositif selon l'une quelconque des revendications précédentes, ***caractérisé* en ce *que*** le ventilateur (21) est placé dans une partie supérieure d'une paroi (25) ou porte du boîtier qui fait face au bac (6) du filtre avec le filtre (4).

15. Dispositif selon l'une quelconque des revendications précédentes, ***caractérisé en ce qu'**un* (27) canal d'air usé avec des ouvertures (28) pour l'air usé placées côté fond est formé dans une paroi (25) ou porte du boîtier, ouvertures par lesquelles l'air usé (7) aspiré par le ventilateur (21) peut être évacué vers l'environnement du boîtier.
